# EUROPEAN PATENT SPECIFICATION

(11) **EP 4 787 004 B1**
(45) Date of publication and mention of the grant of the patent: **11.11.2026**
(21) Application number: 25155384.8
(22) Date of filing: 31.01.2025
(51) Int. Cl.: G01R 33/46, G01R 33/24, G01R 33/3875

(54) **SYSTEM AND METHOD FOR IMPROVING NMR MEASUREMENT RESULTS FOR A SAMPLE**
SYSTEM UND VERFAHREN ZUR VERBESSERUNG VON NMR-MESSERGEBNISSEN FÜR EINE PROBE
SYSTÈME ET PROCÉDÉ POUR AMÉLIORER LES RÉSULTATS DE MESURE RMN POUR UN ÉCHANTILLON

(43) Date of publication of application: 05.08.2026
(73) Proprietor: Bruker Biospin GmbH & Co. KG, 76275 Ettlingen (DE)
(72) Inventor: Fey, Michael, Billerica, MA 01821 (US); Fischer, Christian, 76287 Rheinstetten (DE); Cobas, Juan Carlos, 15705 Santiago de Compostela (ES)
(74) Representative: Fleuchaus & Gallo Partnerschaft mbB

(56) References cited:
- ZHU M. ET AL.: "Improved Proton NMR Thermometry by Field Inhomogeneity Correction Post-Processing", PROCEEDINGS OF THE INTERNATIONAL SOCIETY FOR MAGNETIC RESONANCE IN MEDICINE - JOINT ANNUAL MEETING ISMRMB-ESMRMB, vol. 15, 19 May 2007 (2007-05-19), pages 1403, XP040600582
- METZ K. R. ET AL: "Reference deconvolution: A simple and effective method for resolution enhancement in nuclear magnetic resonance spectroscopy", CONCEPTS IN MAGNETIC RESONANCE, vol. 12, no. 1, 2 December 1999 (1999-12-02), US, pages 21 - 42, XP093291363, ISSN: 1043-7347, DOI: 10.1002/(SICI)1099-0534(2000)12:1<21::AID-CMR4>3.0.CO;2-R
- JIRU ET AL: "Introduction to post-processing techniques", EUROPEAN JOURNAL OF RADIOLOGY, ELSEVIER SCIENCE, NL, vol. 67, no. 2, August 2008 (2008-08-01), pages 202 - 217, XP022832877, ISSN: 0720-048X, [retrieved on 20080423], DOI: 10.1016/J.EJRAD.2008.03.005
- GARETH A. MORRIS ET AL: "Reference deconvolution methods", PROGRESS IN NUCLEAR MAGNETIC RESONANCE SPECTROSCOPY., vol. 31, no. 2-3, September 1997 (1997-09-01), GB, pages 197 - 257, XP055328657, ISSN: 0079-6565, DOI: 10.1016/S0079-6565(97)00011-3
- KARABANOV ALEXANDER ET AL: "Post-acquisition correction of NMR spectra distorted by dynamic and static field inhomogeneity of cryogen-free magnets", JOURNAL OF MAGNETIC RESONANCE., vol. 353, August 2023 (2023-08-01), US, pages 107494, XP093165128, ISSN: 1090-7807, DOI: 10.1016/j.jmr.2023.107494

## Description

### Technical Field

The present invention generally relates to NMR spectroscopy and more particularly to improved NMR measurement results by applying corrections for inhomogeneities in the magnetic field of an NMR spectrometer.

### Background

For analyzing NMR measurement results (NMR spectra), sharp, symmetric line shapes of the measured spectrum peaks are advantageous. However, when inserting a sample into the magnetic field of the NMR spectrometer, the magnetic field gets distorted resulting in broadened and unsymmetric peaks in the measured spectra. In an inhomogeneous field, nuclear spins at different positions may experience different field strengths and have different resonance frequencies. Therefore, an inhomogeneous magnetic field causes peak broadening and distortion in NMR spectra. Due to factors like the magnet, probe, and sample, there are always residual inhomogeneities in the B₀ field that can degrade the quality of an NMR spectrum. Thereby, the sample in the magnet field adds to the distortions which are individual for each sample. To compensate for such inhomogeneities of the magnetic field, shim coils of the NMR spectrometer are usually used to homogenize the magnetic field. Each shim coil is designed to generate a unique static field distribution per unit current and is connected to an independent current source. The process of finding the optimal setting of the shim currents to best compensate for the B₀ field inhomogeneities is known as shimming. Shimming is an iterative process (manual or automatic) that can be time consuming depending on the accuracy and the desired amplitudes of the residual inhomogeneities. Even a 1D shimming process may take up to 180 seconds, especially in cases with low signal-to-noise ratio (SNR) on the solvent. In high throughput screening, usually single scan measurements are performed, which take around 5-10 seconds, so that the shimming process is the time-determining step.

In some prior art approaches, unsymmetric, distorted line shapes are corrected by Reference Deconvolution. An example of the Reference Deconvolution approach is disclosed in the paper Metz K. R. ET AL: "Reference deconvolution: A simple and effective method for resolution enhancement in nuclear magnetic resonance spectroscopy", CONCEPTS IN MAGNETIC RESONANCE, vol. 12, no. 1, 2 December 1999 (1999-12-02), pages 21-42, XP093291363, US ISSN: 1043-7347, DOI: 10.1002/ (SICI)1099-0534(2000)12:1 21::AID-CMR43.0.CO;2-R. Reference deconvolution works by selecting a well-defined peak, termed the "reference line," from an NMR spectrum, which encapsulates the field inhomogeneity experienced across all peaks. By deconvolving this reference line from the spectrum, the approach removes the inhomogeneity effects, leading to improved spectral resolution. However, such a reference line (a single free/isolated signal) is often not available in a measured spectrum. Signals with different line width add additional challenges to find such a reference. Other prior art approaches using Al solutions also require an isolated signal and comprehensive training. The paper ZHU M. ET AL.: "Improved Proton NMR Thermometry by Field Inhomogeneity Correction Post-Processing", PROCEEDINGS OF THE INTERNATIONAL SOCIETY FOR MAGNETIC RESONANCE IN MEDICINE - JOINT ANNUAL MEETING ISMRMB-ESMRMB, vol. 15, 19 May 2007 (2007-05-19), page 1403, XP040600582, discloses a method which does not rely on reference lines from the spectrum, but which proposes an approach where the correction itself is conceptualized and applied as a time-dependent modification to the acquired time-domain FID signals.

### Summary

There is therefore a need to provide system and method to improve NMR measurement results independent of the spectrum shape while improving shimming or even completely avoiding shimming to increase NMR measurement throughput. This problem is solved by embodiments of the herein disclosed approach as depicted by the independent claims.

In one embodiment, a computer-implemented method is provided for improving an NMR measurement result obtained by an NMR spectrometer for a sample. The method starts with receiving a magnetic field map for the actual main magnetic field of the NMR spectrometer with the sample being located at its measuring position. The magnetic field map is obtained from a measurement of the deviation ΔB of the actual magnetic field from an ideal homogenous field B₀ as a function of spatial location in the sample (i.e., the spatial locations inside the spatial extension of the sample). Further, a spectroscopic time domain NMR measurement of the sample is received. Typically, such a time domain measurement is an acquisition of the so-called Free Induction Decay (FID). Thereby, an NMR experiment is performed using an excitation pulse at a defined flip angle, followed by the acquisition of the free induction decay.

B₀ denotes the reference value for the z component of the static magnetic field, and setting the receiver frequency to -γ B₀ provides spectral intensities as a function of the frequency Ω in the rotating frame of reference, with γ as the gyromagnetic ratio of the respective nucleus in [MHz/T]. This frame rotates at the same frequency as the precessing nuclear spins, simplifying the analysis by making the spins appear nearly stationary. For spatially constant B₀, the resulting spectrum I(Ω) of such an experiment and the corresponding calculation is, apart from an arbitrary scaling constant, a single Lorentz line of width λ = 1/(πT2) centered around zero frequency $I \left(Ω\right) = L \left(Ω, λ\right) .$

The B₀ field map measures the deviation of the magnetic field as a function of spatial location in the sample, B₀(**r**). Thereby, magnetic field measurement points are taken at z-intervals in the z-direction of the sample (direction along the magnet bore of the NMR spectrometer). In a preferred embodiment, the z-intervals are equidistant. The shifts of the resonance frequency are changed by Ω₀(r) = - γ B₀ (r). A correction function for the NMR measurement is then computed in the frequency domain based on the received magnetic field map. In general, this is achieved by determining, for each of a plurality of predefined frequency intervals covering a frequency range with B₀ deviations, the total length of z-intervals with frequency values in each respective frequency interval, wherein the determined total length is the value of the correction function for the respective frequency interval. In one embodiment, the total length of z-intervals is calculated by determining, for each of a plurality of predefined frequency intervals covering a frequency range with B₀ deviations, the number of data points in the received magnetic field map with frequency values in each respective frequency interval. The determined number of data points is then used as the value of the correction function for the respective frequency interval.

In more detail, the full spectrum can be calculated as the integral over the sample volume: $I \left(Ω\right) = {\int }_{r} L \left(Ω-{Ω}_{0}\left(r\right)\right) {d}^{n} r$ Expanding the expression with a delta function: $I \left(Ω\right) = {\int }_{r} {\int }_{Ω ′} L \left(Ω-Ω′\right) δ \left(Ω-{Ω}_{0}\left(r\right)\right) d Ω ′ {d}^{n} r$ enables rewriting it as a product of two functions of frequency $I \left(Ω\right) = {\int }_{Ω ′} L \left(Ω-Ω′\right) H \left(Ω′\right) d Ω ′$ where $H \left(Ω\right) = {\int }_{r} δ \left(Ω-{Ω}_{0}\left(r\right)\right) {d}^{n} r$ is the weighted histogram of the spatial variation in response to frequencies. Hence, the spectrum in an inhomogeneous medium is given by convolving it with a histogram of natural disturbances *H*(Ω): $I \left(Ω\right) = L \left(Ω, λ\right) ⊗ H \left(Ω\right)$

The influence on the spectral shape of a signal can be computed as the convolution of the undisturbed signal shape with a kernel (correction function) H(Ω). The kernel can be computed as follows: The Ω₀ -map is given as a function in space, usually the size of the sample, in some magnetic offset, given in units of Hz of nucleus frequency.

Assuming enough resolution in z-direction, a simple way to compute the kernel in a frequency interval Ω to Ω +Δ Ω is to count all points of the Ω₀-map, that are lying in this interval, i.e., that have a value between Ω and Ω +Δ Ω. In regions of strong gradients in the Ω₀-map, this may lead to discretization errors and artificial peaks. A refinement of the data by interpolation may be used to resolve this issue.

The analytical expression for the kernel would be: $H \left(Ω\right) = \frac{1}{{Ω}_{0}^{′} \left({Ω}_{0}^{- 1}\left(Ω\right)\right)}$ While this formally seems to diverge for points with zero derivative, the integral stays bound which can be used for any implementation.

Turing back to the above-described discretized version of the kernel (correction function) with values as the integral from Ω to Ω +Δ Ω, one obtains the sum of the length of intervals in the z direction that are within the frequency range. This defines the kernel H(Ω) in an analytical way and no longer dependent on the resolution of the Ω₀-map. Some interpolation on the discrete data points of a measured map may be advantageous to get the intersection points for the computation. In other words, computing the correction function may include interpolation of frequency intervals between points of the received magnetic field map.

In one embodiment, the kernel (correction function) may be weighted by the B₁ map taking into account deviations of the actual magnetic field caused by the B₁ field of the NMR spectrometer's RF coil: $H \left(Ω\right) = {\int }_{r} δ \left(Ω-{Ω}_{0}\left(r\right)\right) w \left(r\right) {d}^{n} r$ with w(**r**) = sin(B1(**r**) α)B1(**r**).

It is to be noted that H needs to be properly scaled since the convolution with the kernel will not destroy or generate the signal, but only redistribute it. Therefore, the integral of the real part of I after the convolution is the same as the integral of the original function L.

The correction function extracted from the magnetic field map is then transformed into the time domain by using an appropriate transformation function (e.g., a Fourier Transform FFT). A first regularization function adapted to prevent increase of noise or artifacts is applied to the transformed correction function in that, for all values of the correction function being smaller than a predefined threshold, these values are normalized to the predefined threshold while keeping their phase. The transformed correction function after regularization is then used as the transformed correction function for the following division.

To apply the "de-convolution", the kernel is transformed into the time domain (e.g., by an inverse FFT transform) and the time domain NMR measurement is divided by the kernel. In other words, the time domain NMR measurement is then divided by the transformed correction function to obtain a corrected time domain NMR measurement curve. The corrected time domain NMR measurement curve can be interpreted as a simulation of the NMR measurement result which compensates the measurement for the inhomogeneity in the magnetic field map. That is, the repeated use of shim coils in a relatively long-lasting shimming process is substituted by a fast computed correction after the NMR measurement has been acquired.

The corrected time domain NMR measurement curve is finally transformed into the frequency domain to obtain an NMR spectrum of the sample based on the corrected time domain NMR measurement. Because of the corrections applied via said correction function, the resulting NMR spectrum has symmetrized peaks, with reduced overlapping.

The measurement times when using traditional shimming techniques are significantly reduced with the herein disclosed approach using a correction function simulating the shimming effects on an acquired time domain NMR measurement while providing an accuracy in the resulting NMR spectra being comparable with the accuracy achieved by traditional shimming.

In some situations, the deviations in the magnetic field map may be too large to be corrected using the herein disclosed correction function. A threshold can be predefined to indicate a boundary for a meaningful use of the correction function. That is, if the deviation is equal to or greater than such predefined threshold, control instructions may be provided to one or more shim coils of the NMR spectrometer to improve the homogeneity of the main magnetic field B₀. After the control instructions have led to new settings for the NMR spectrometer, the magnetic field map under the new settings is received. This can be repeated until said deviation falls below the predefined threshold where the deviations can be well corrected via said correction function.

In one embodiment, the received magnetic field map is a three-dimensional shim map. Using a three-dimensional shim map correction leads to the most accurate correction function. However, measuring a three-dimensional shim map correction is time consuming.

The kernel H(Ω) in frequency domain is real by construction. However, the transformed kernel (correction function) in the time domain after the inverse FFT consists of complex numbers and the division is done with the complex values (having a real part and an imaginary part). A kernel function which can be used to sharpen an originally measured spectrum may lead to lowering the signal/noise ratio, or to failure due to division by zero. To stabilize this process, a regularization can be applied to balance resolution vs. signal/noise ratio or the appearance of artefacts.

In one embodiment, a second regularization function is then applied to the corrected time domain NMR measurement curve, in particular for such values where the regularized transformed correction function is normalized to the threshold. The second regularization function can replace values of the corrected time domain NMR measurement curve obtained from such normalized values of the regularized correction function by various regularization strategies such as interpolation or iterative soft thresholding.

A skilled person could apply an additional regularization function reducing the weights of values in the tail of the corrected time domain NMR measurement curve. A preferred method is the multiplication of the time domain NMR measurement with an exponential decay with a decay rate of the expected average line width.

In one embodiment, a filtering step can be included before applying the correction function. The filtering is applied to the received time domain NMR measurement to filter out signal contributions of components which are known for disturbing the correction. For example, the contribution of a residual solvent is filtered out using a respective predefined frequency filter (e.g., a Finite Impulse Response (FIR) filter with a Blackman window).

It is to be noted that one or more one initial shimming steps may be performed by default prior to the acquisition of the magnetic field map and time domain NMR measurement which are provided as inputs to the herein disclosed computer-implemented method. This leads to less artefacts in the corrected spectrum and an improved SNR.

Further aspects of the invention will be realized and attained by means of the elements and combinations particularly depicted in the appended claims. It is to be understood that both the foregoing general description and the following detailed description are exemplary and explanatory only and are not restrictive of the invention as described.

### Brief description of the figures

FIG. 1 is a block diagram showing an embodiment a computer system for improving an NMR measurement result obtained by an NMR spectrometer for a sample;
FIG. 2 is a flow-chart of an embodiment of a computer-implemented method for improving an NMR measurement result obtained by an NMR spectrometer for a sample;
FIGs. 3A, 3B show an example of a discrete and interpolated magnetic field map for the actual main magnetic field of the NMR spectrometer;
FIGs. 3C, 3D show an example of a discrete and interpolated magnetic field map of the actual magnetic field caused by the B₁ field of the NMR spectrometer's RF coil;
FIG. 3E shows an example peak in a measured spectrum without correction;
FIG. 3F shows the example peak of the measured spectrum after applying correction according to an embodiment;
FIGs. 4A to 4D illustrate, for a schematic example of a magnetic field map, the determining of values of a respective correction function according to an embodiment;
FIG. 5A illustrates an example of a correction function in the time domain computed from an actual magnetic field map;
FIG. 5B shows an example of a correction function after its transformation into the frequency domain;
FIG. 5C illustrates an example of a correction function in the time domain computed from an actual magnetic field maps from the main magnetic field with and without the impact caused by the B₁ field;
FIG. 6 shows an example of an original time domain NMR measurement curve and the respective corrected time domain NMR measurement curve after application of the correction function;
FIG. 7 illustrates an embodiment using interpolation of the magnetic field map to compensate for missing measurement points in a respective interval.
FIG. 8A illustrates schematically how to handle correction function values close to zero by using thresholding;
FIG. 8B shows an example of a corrected peak using regularization;
FIGs. 8C, 8D illustrate the effect of regularization method examples on artefacts caused by hard thresholding in a corrected time domain measurement curve;
FIGs. 9A, 9B illustrate the effect of various regularization thresholds on NMR spectra obtained from corrected time domain NMR measurement curves;
FIG. 10A shows examples of uncorrected NMR spectra obtained while using various shimming levels;
FIG. 10B shows examples of corrected NMR spectra obtained while using various shimming levels; and
FIG. 11 is a diagram showing an example of a generic computer device and a generic mobile computer device, which may be used with the techniques described herein.

### Detailed description

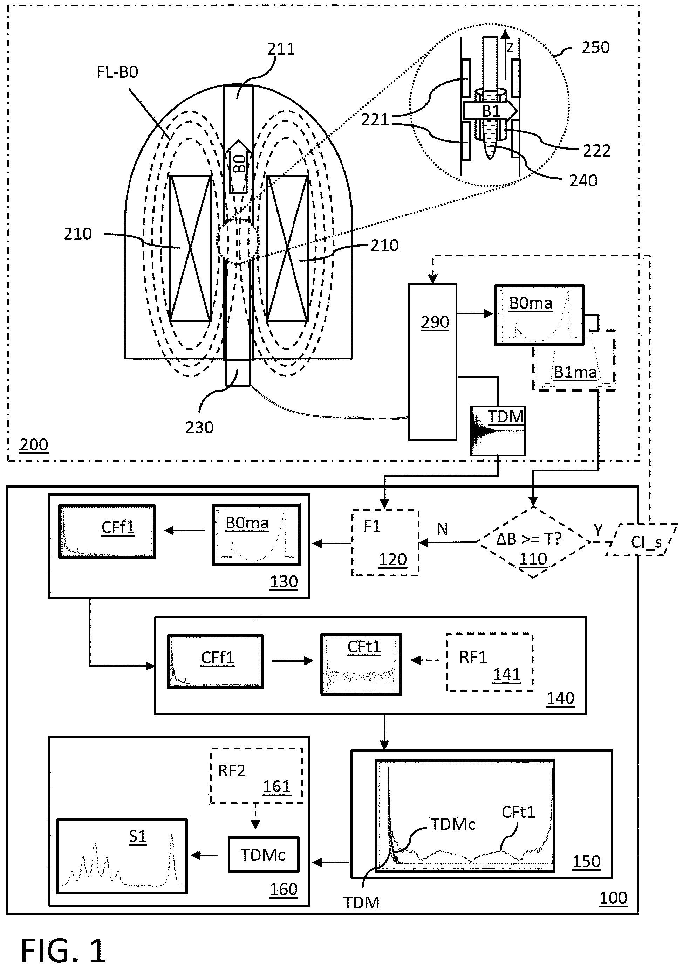

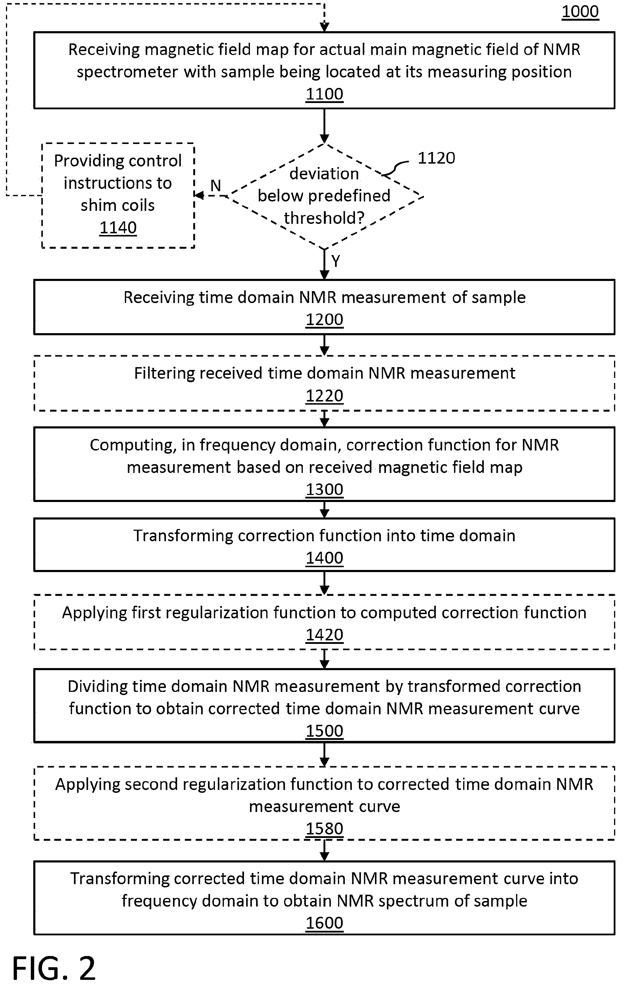

FIG. 1 is a block diagram showing an embodiment of a computer system 100 for improving an NMR measurement result obtained by an NMR spectrometer 200 for a sample 240. FIG. 2 is a flow-chart of an embodiment of a computer-implemented method 1000 for improving an NMR measurement result obtained by an NMR spectrometer for a sample. Method 1000 can be executed by computer system 100. In the following, the computer system 100 in FIG. 1 is described in view of the flow chart of FIG. 2. Therefore, the following part of the description refers to reference numbers of both figures without indicating the respective figure.

The computer system 100 is communicatively coupled with a console 290 of the NMR spectrometer 200 via a data interface (not shown) adapted to receive 1100 a magnetic field map BOma for the actual main magnetic field B0 of the NMR spectrometer with the sample 240 being located at its measuring position. The magnetic field map BOma is obtained from a measurement of the deviation of the actual magnetic field from an ideal homogenous field B0 as a function of spatial location in the sample. Without a sample, a superconducting NMR magnet 210 generates B0 field lines FL-B0 which form a homogenous magnetic field B0 in the magnet bore 211 of the NMR spectrometer 200. The magnet bore 211 extends along the z-direction (indicated by arrow z in the zoomed area 250). In FIG. 1, a removable NMR-probe 230 is inserted into the magnet bore carrying the sample 240 at the location indicated by circle 241 which causes a distortion of the B0 field (i.e., deviations from the homogenous shape without a sample). The method for obtaining the magnetic field map BOma is well known by a person skilled in the field of NMR spectroscopy.

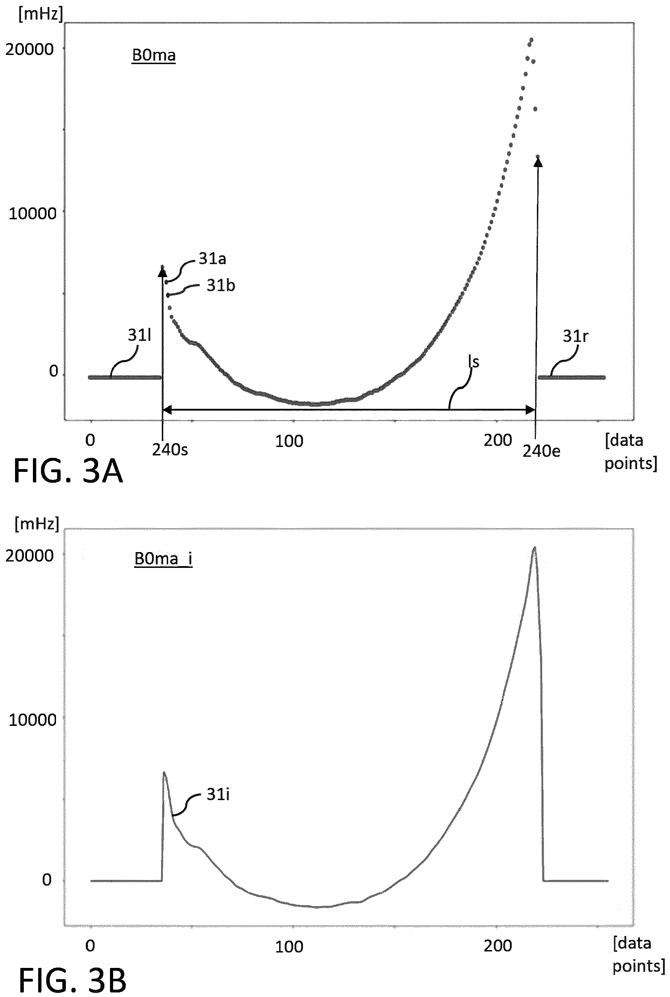

FIG. 3A illustrates a measurement result for an example magnetic field map BOma showing the deviations of the actual magnetic field B0 from an ideal homogenous B₀ field. The points 311, 31r with value 0 at the left and right end of BOma indicate regions in the magnetic bore 211 which are outside of the measured section Is of the sample. The points 240s, 240e indicate the end points of the sample. In this example, the unit of the x-axis is in data points wherein 1 point corresponds to 0.124 mm. That is, the distance between two consecutive measurement points (e.g., 31a, 31b) is 0.124 mm (here all points are equidistant). The length Is of the sample is therefore: Is = 240e - 240s. That is, the sample spatially extends from 240s to 240e where the measured values (in Millihertz [mHz]) of the actual magnetic field significantly deviate from the ideal homogenous field. FIG. 3B shows an interpolated field map B0ma_i where an interpolation curve 31i is computed through all measurement points of BOma. It is to be noted that the original received magnetic field map BOma always consists of discrete measurement points. FIGs. 3A, 3B illustrate examples of two-dimensional magnetic field maps. However, the received magnetic field map can also be a three-dimensional shim map.

Further, system 100 receives 1200 a time domain NMR measurement TDM of the sample 240. As mentioned earlier, typically, such a time domain measurement is an acquisition of the so-called Free Induction Decay (FID). The FID is the observable nuclear magnetic resonance signal generated by non-equilibrium nuclear spin magnetization precessing about the magnetic field, conventionally along the z-direction. This non-equilibrium magnetization is created by using RF coil 222 to apply to the sample 240 a pulse of radio-frequency close to the Larmor frequency of the nuclear spins resulting in the magnetic field B1.

System 100 has a function generator module 130 adapted to compute 1300, in the frequency domain, a correction function CFf1 for the NMR measurement TDM based on the received magnetic field map BOma. It is to be noted that, in the absence of optional modules 110, 120 (described further down below), TDM and BOma are directly used as input for module 130. Correction function CFf1 corresponds to the above-described kernel *H*(Ω). As the received magnetic field map BOma consists of discrete measurement points, the value of the correction function for a particular frequency interval is determined by counting the number of points in the received magnetic field map in the particular frequency interval. This computation is performed for each frequency interval values in a plurality of predefined frequency intervals covering a frequency range with B0 deviations.

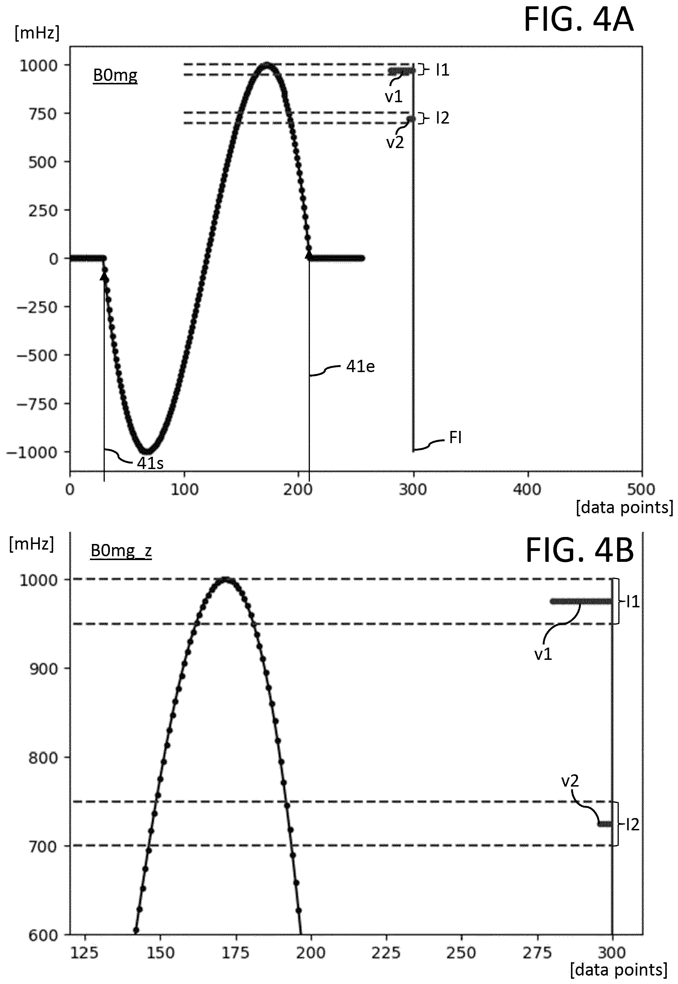

The computation of the values of the correction function CFf1 is illustrated in more detail in schematic FIGs. 4A, 4B. These figures are for illustrative purposes only and do not show a measured magnetic field map but rather a generated magnetic field curve BOmg with computed points. In the example of FIG. 4A, the sample length extends from point 41s to point 41e defining the spatial region with a distorted B0 field. Two equidistant example frequency intervals I1, I2 in the region with B0 deviations are indicated by horizontal dashed lines. The bars V1, V2 represent the number of BOmg points in the respective frequency intervals I1, I2. The number of values is lower in frequency intervals where BOmg has a lower slope than in frequency intervals where BOmg has a higher slope because the BOmg points are equidistant in the z direction (along the sample length). The equidistant frequency intervals (I1, I2, etc.) can be interpreted as defining the x-axis FI of the correction function whereas the value bars (V1, V2, etc.) extend along the y-axis of the correction function CFf1. Advantageously, the size of a frequency interval corresponds to the spectral resolution of the measured frequency spectrum (typically 0.05 to 0.20 Hz/data point). The result of the CFf1 computation 1300 is therefore a kernel function with discrete values which are equidistant in the frequency domain (distance corresponds to the size of a frequency interval). FIG. 4B shows a zoomed-in view of the upper portion B0mg_z of FIG. 4A with points showing a deviation above 600 Hz. In this example, the size of the frequency intervals I1, I2, etc. is 50 mHz. In general, the frequency interval size is equal to the frequency resolution (i.e., the distance between two measured data points) of the spectrum which is to be corrected. In I2, four points are counted, leading to V2 = 4. In I1, 18 points are counted, leading to V1 = 18. To summarize, in such discretized version of the correction function with values as the integral from Ω to Ω +Δ Ω, module 130 obtains the sum of the length of (equidistant) z-intervals (between the B0mg_z points in the z direction) that are within a respective frequency interval.

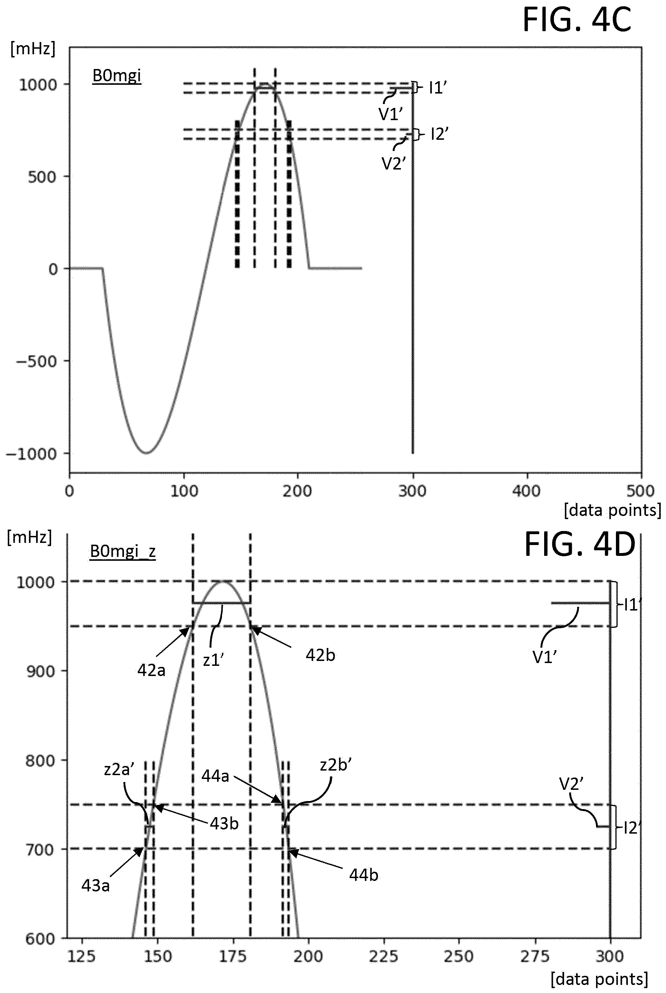

FIGs. 4C, 4D show the same situation as FIGs. 4A, 4B, but now with the length of the z-intervals as the measure for the kernel values. This defines the kernel H(Ω) in an analytical way and no longer dependent on the resolution of the Ω₀-map. Interpolation on the discrete points of a magnetic field map allows to get relevant intersection points between the magnetic field map curve and the boundaries of the frequency intervals for the computation. In the example, the computed points of BOmg are interpolated resulting in the interpolated map B0mgi (B0mgi_z). The intersections 42a, 42b, 43a, 43b, 44a, 44b of the boundaries of a frequency interval (e.g., I1', I2') with the interpolated magnetic field map curve (e.g., B0mgi_z) define the endpoints of the respective z-intervals z1', z2a', z2b'. For frequency interval I1' the corresponding kernel value V1' corresponds to the length of the z-interval z1' as the entire magnetic field map in this frequency interval is between the intersections 42a and 42b (because the maximum of the magnetic field map curve lies in I1'. For I2', one part of the kernel contribution is in the rising edge of the magnetic field map between intersections 43a and 43b with length z2a', and one part is in the declining edge between intersections 44a and 44b with length z2b'. For I2' the corresponding kernel value is computed as V2'=z2a'+z2b'.

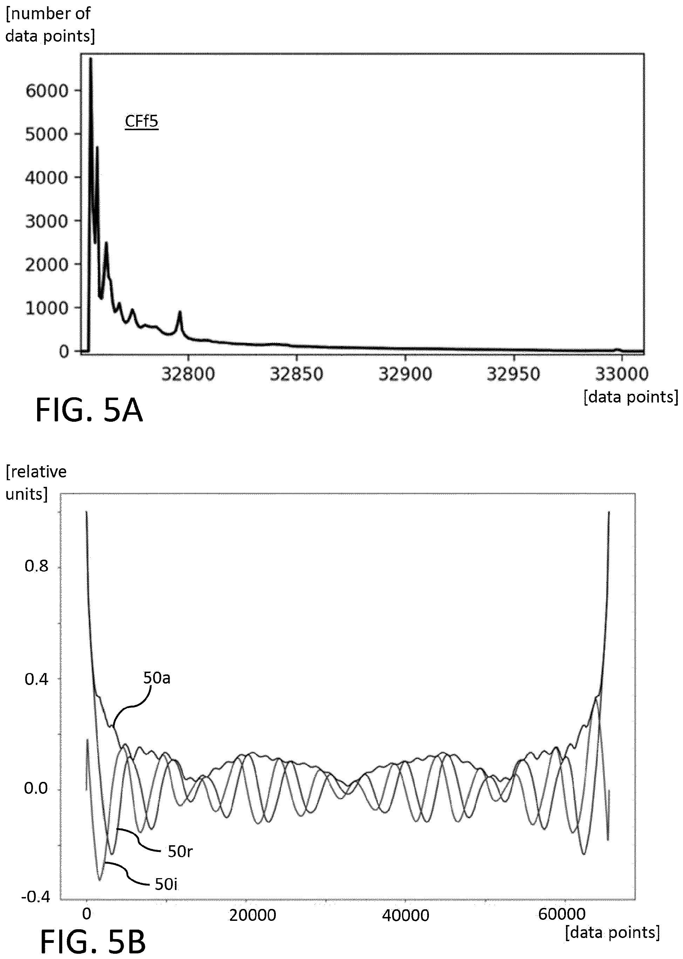

FIG. 5A shows a part of an example correction function CFf5 in the frequency domain which has been computed 1300 from a real actual magnetic field map of the main magnetic field B0. The shown part is a zoomed view which shows a part of the entire correction function which has the highest correction impact with regard to a respective corrected NMR spectrum. Thereby, CFf5 is shown as an interpolated curve whereas the computation was actually performed based on the discrete measurement points of the magnetic field map.

System 100 further has a frequency-to-time-domain transformation module 140 adapted to transform 1400 the correction function CFf1 into the time domain. The transformation into the time domain is advantageous as it allows to apply the transformed correction function directly to the received time domain NMR measurement data TDM. For example, module 140 can be implemented as an inverse FFT. FIG. 5B shows an example of a transformed correction function (kernel in the time domain). Because of the nature of the inverse FFT, the transformed correction function has a real part 50r and an imaginary part 50i. The absolute value of the transformed correction function is scaled to 1 and is shown as curve 50a and corresponds to the transformed correction function CFt1 in FIG. 1. That is, the units of the y-axis are relative units, where the value of the first data point is '1'.

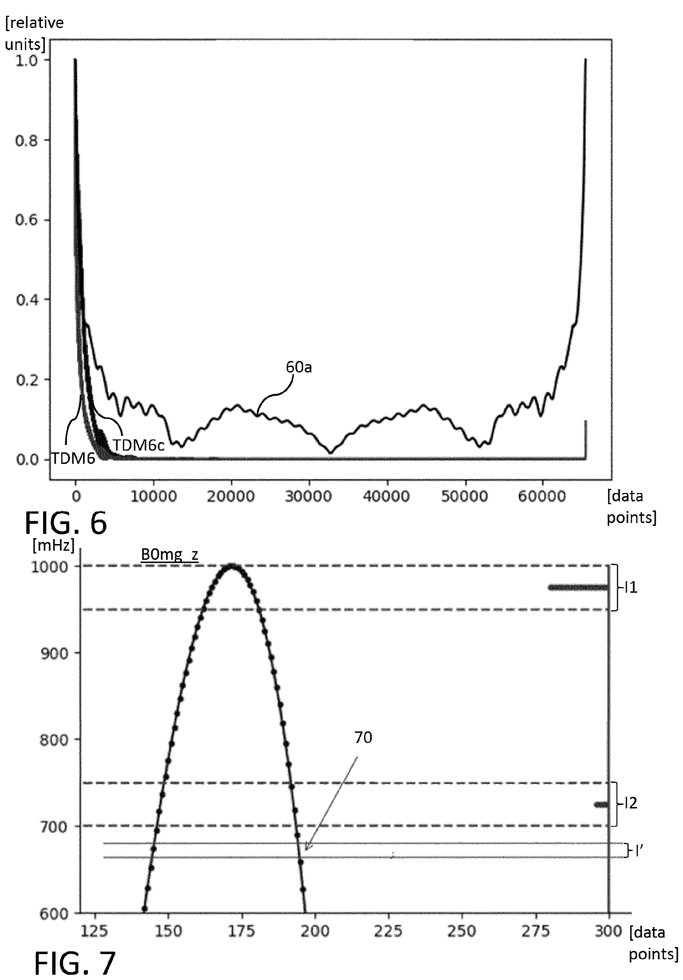

A correction module 150 of system 100 is adapted to divide 1500 the time domain NMR measurement TDM by the transformed correction function CFt1 to obtain a corrected time domain NMR measurement curve TDMc. FIG. 6 illustrates the time domain with an example of the absolute values of a transformed correction function 60a, originally received time domain NMR measurement data TDM6 and the corresponding corrected time domain NMR measurement curve TDM6c after the deconvolution of TDM6 with transformed kernel 60a (i.e., the division of curve TDM6 by curve 60a).

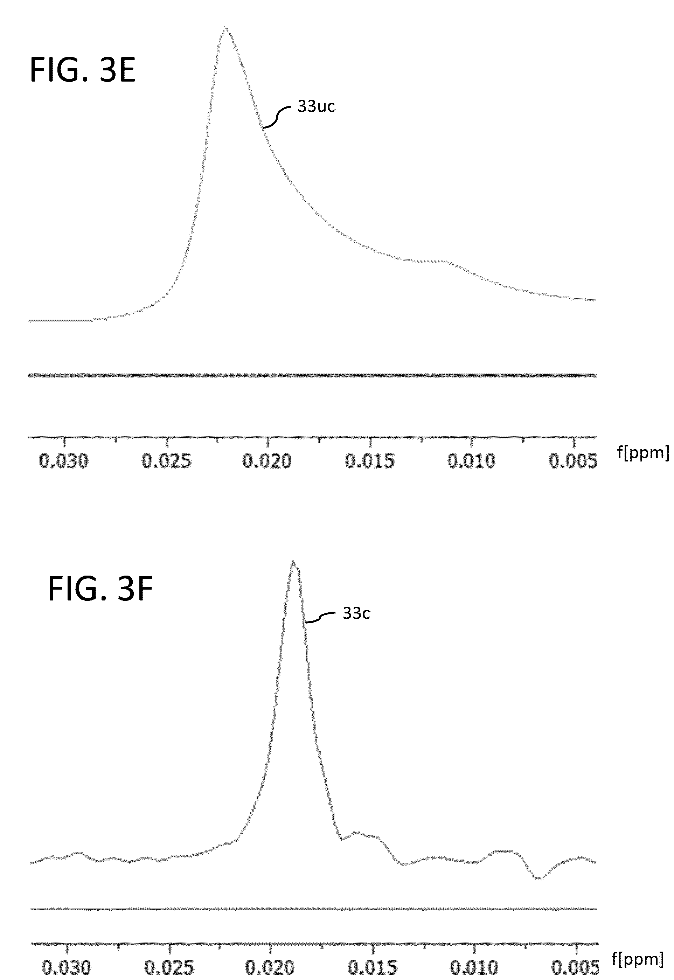

A time-to-frequency-domain transformation module 160 of system 100 is adapted to transform 1600 the corrected time domain NMR measurement curve TDMc into the frequency domain to obtain an NMR spectrum S1 of the sample 240 with symmetrized peaks and overlapping peaks being resolved. Module 160 may be implemented as a Fast Fourier Transformation FFT. FIG. 3E shows a peak 33uc in an uncorrected NMR spectrum. That is, the spectrum has been obtained directly from the respective time domain NMR measurement data. FIG. 3F shows a peak 33c in an NMR spectrum which has been corrected by using the herein disclosed correction method to eliminate artefacts caused by the distorted B0 field. Thereby peak 33c corresponds to peak 33uc in that it relates to the same component in the sample. Peak 33c of the corrected spectrum is sharper, more symmetric and is located a slightly higher frequency. From the corrected spectrum, more accurate information regarding the component and its concentration in the measured sample can be derived.

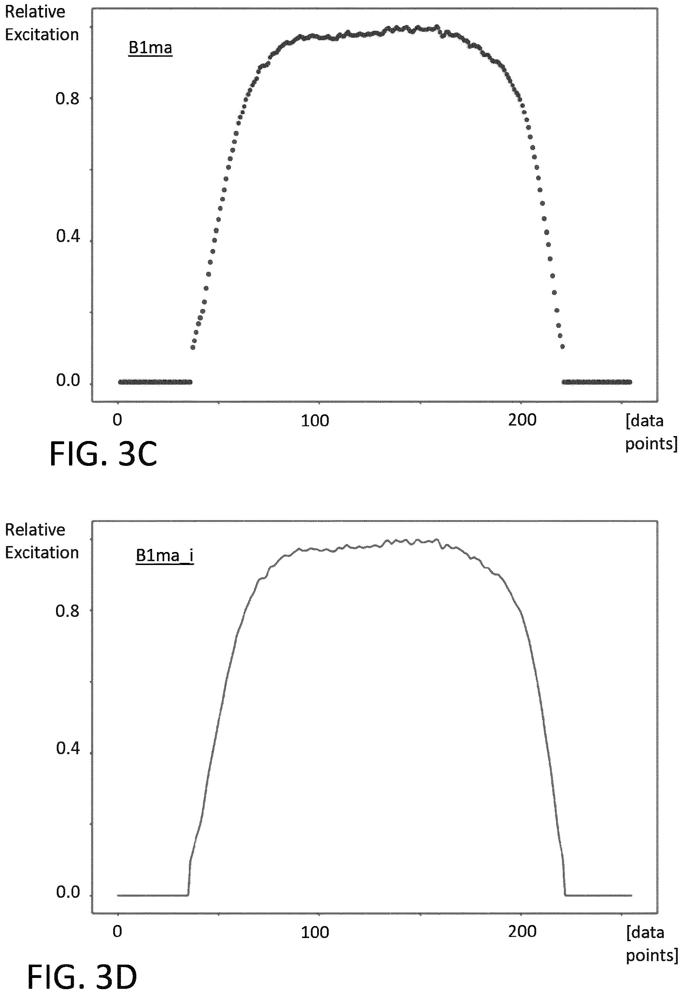

In an optional embodiment, the herein disclosed method 1000 and system 100 can also take into account the impact of the B₁ field of the NMR spectrometer's RF coil 222 when computing the correction function. In this embodiment, the received magnetic field map further includes deviations B1ma from the actual magnetic field caused by the B₁ field. FIG. 3C shows an example of a B1 related magnetic field map B1ma. The B1 field is the radio-frequency field used to flip the magnetization of the spins in the sample. A B₁ field map allows to determine the homogeneity and strength of the B₁ field in different areas of the sample. In an ideal situation, the B1 field should be the same for every position. As in FIG. 3A, the data points with a value of 0 indicate the area outside of the measured section of the sample. The deviating points are measured at the location of the sample (same sample as in FIG. 3A). FIG. 3D shows an interpolation B1ma_i of the B₁ field map in FIG. 3C.

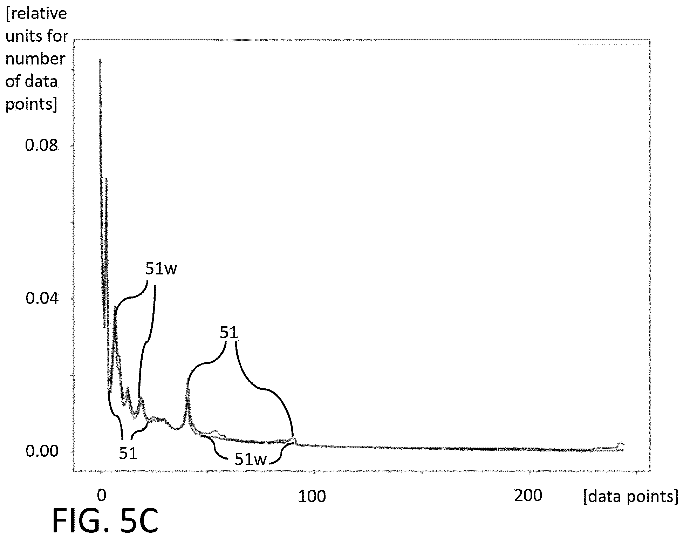

For computing the correction function in this embodiment, the previously discussed formula: $H \left(Ω\right) = {\int }_{r} δ \left(Ω-{Ω}_{0}\left(r\right)\right) w \left(r\right) {d}^{n} r$ shows that the kernel function in this embodiment is weighted by the B₁ map. FIG. 5C illustrates the differences between the correction function 51 with no weighting (only based on the B0 magnetic field map) and the correction function 51w according to this embodiment with weighting (also taking into account the impact of the B1 magnetic field map). For the following steps of method 1000, this embodiment uses the weighted correction function 51w.

In a further optional embodiment, system 100 has shim control module 110 adapted to check 1120 if the deviation ΔB (from the homogenous magnetic field B0) is equal to or greater than a predefined threshold T (a typical value for the predefined threshold is in the order of 500 mHz as a maximum deviation). If this is the case (Y), module 110 provides 1140 control instructions CI_s for one or more shim coils 221 to the NMR spectrometer 200 to reduce the inhomogeneity of the main magnetic field B0. Otherwise (N), the system directly continues with the computation of the correction function DFf1 for time domain NMR measurement data TDM acquired once ΔB is below said predefined threshold. In case of a one-step shimming process, the system would continue with the correction method. However, the system may also perform multiple shimming steps in which case a new magnetic field map is received after the control instructions have been applied with a subsequent measurement of the spatial distribution of the magnet field. If the deviation ΔB is still above the predefined threshold, the shimming process is repeated until the deviation reaches of falls below said threshold. The generation of shimming control instructions CI_s based on magnetic field map measurements is well known in the technical field of NMR spectroscopy. When using the shim control module 110, system 100 can avoid a situation where magnetic field maps are received with measured magnetic field inhomogeneities being too large to get good measurement results for respective NMR spectra even when applying the herein disclosed correction method. By initially executing one or more shimming steps via the shim coils 221, the magnetic field inhomogeneities can be reduced to a level which guarantees very good results when applying the herein disclosed correction method.

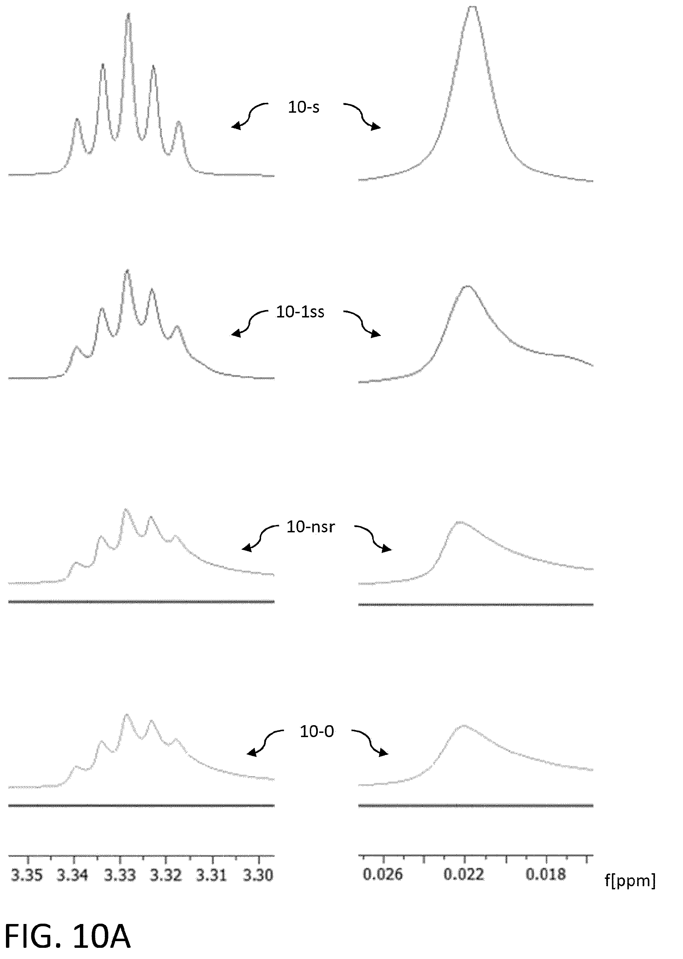

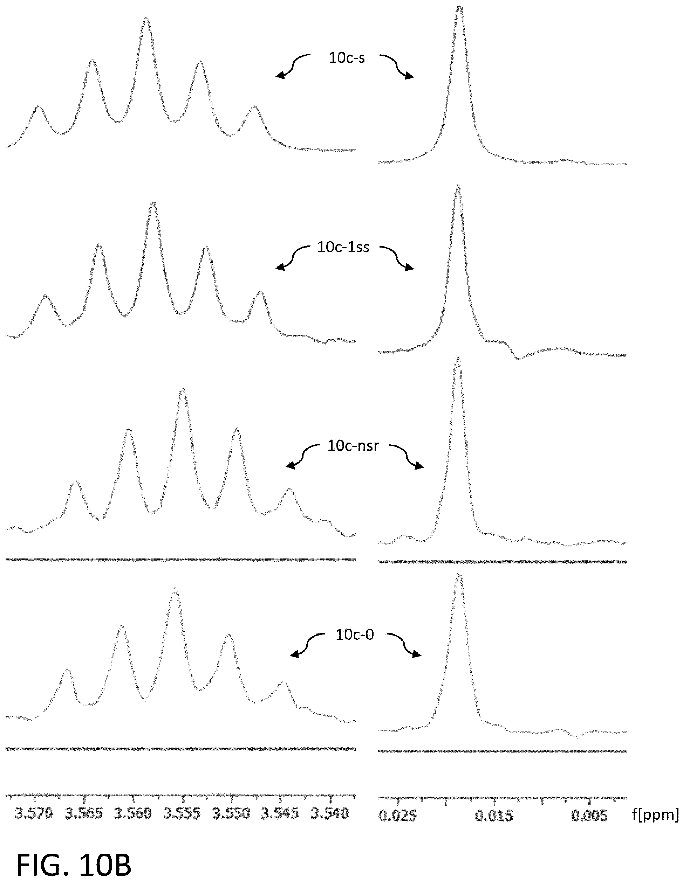

FIGs. 10A, 10B illustrate the impact of shimming on the shape of NMR spectra obtained from time domain NMR measurement without and with using the claimed correction method. FIG. 10A shows only part of NMR spectra which were obtained for various shim levels without using the correction function. The spectrum parts 10-0 are directly obtained from time domain NMR measurement data where no shimming at all was applied prior to the acquisition of the NMR measurement data. The peaks show a low level of symmetry and are very broad which makes it difficult to determine reliable information about the concentration of the underlying components in the sample. For the spectrum parts 10-nsr, no shim rotation was applied. For the spectrum parts 10-1ss, a one-step shimming process was applied prior to the acquisition of the NMR measurement data. It can be seen that already a significant improvement of the peak shapes in the obtained spectra is achieved. The spectrum parts 10-s are obtained from NMR measurement data acquired after full shimming (multiple shimming processes) has been applied to the NMR spectrometer. The peaks show a symmetric shape and lower widths than for the other shim levels which allows for a more accurate determination of the sample composition.

FIG. 10B shows NMR spectra obtained from NMR measurement data for the same shim levels as in FIG. 10A but with using the herein disclosed correction method. It can be seen immediately that even the peaks of the spectrum parts 10c-0 obtained, without using any shimming at all, have a symmetric shape and a width which is even narrower than the width of the fully shimmed but uncorrected peaks in the spectrum parts 10_s. That is, the spectra obtained by using the correction method already allow for a highly accurate determination of the sample composition even without any physical shimming applied. It can be seen that the peak shapes in the spectrum peak can even be further improved (in terms of symmetry and peak width), when applying the various shimming levels as illustrated in spectrum parts 10c-nsr (no shim rotation), 10c-1ss (one step shimming) and 10c-s (full shimming). Thereby, the one step shimming already provides a spectrum quality in terms of peak symmetry and width which is almost as good as the spectrum quality with the fully shimmed NMR spectrometer. Therefore, it can even be advantageous to always apply a one-step shimming to the spectrometer before the acquisition of the NMR measurement data even independent of the deviation ΔB.

In an optional embodiment, system 100 may further include a filter module 120 adapted to filter 1220 the received time domain NMR measurement TDM before applying the correction function to filter out signal contributions of components which are known for disturbing the correction. An example of such components is a residual solvent. The filter module 120 may be implemented by a respective predefined frequency filter (e.g., a Finite Impulse Response (FIR) filter with a Blackman window). The filtering out of such correction disturbing signal contributions finally leads to a higher quality of the final corrected spectrum S1 with regard to peak symmetry and width so that the accuracy of a sample composition based on S1 is further improved.

In one embodiment of module 130, computing 1300 the correction function may further include interpolation of frequency intervals between points of the received magnetic field map. This embodiment allows to also handle frequency intervals which do not include discrete measurement points of the received magnetic field map. FIG. 7 corresponds to the zoom view of the generated magnetic field map example B0mg_z of FIG. 4. If, for example, the size of the frequency intervals for counting the measurement points is smaller than the intervals I1, I2 used in the previous example (e.g., the size of I'), it can happen that no measurement point falls into such interval at locations where the slope of the measurement curve is high (e.g., the declining slope of B0mg_z in the interval 70). For such frequency intervals, the respective value of the correction function can be determined in a way as discussed in FIG. 4D.

Applying the transformed correction function to the NMR measurement data introduces noise to the data. Regularization is used to reduce such noise. The frequency-to-time-domain transformation module 140 implements a first regularization function 141 which can be applied to the transformed correction function CFt1 to balance resolution vs. signal-to-noise ratio or the appearance of artefacts. In other words, the first regularization function 141 aims to reduce the increase of noise in the time domain NMR measurement data for particular regions. For example, an FID may have regions of very low SNR. In particular, towards the end of the FID, or in between close peaks, the NMR measurement data represent mainly noise. The first regularization function 141 can prevent or at least reduce the increase of noise or artifacts.

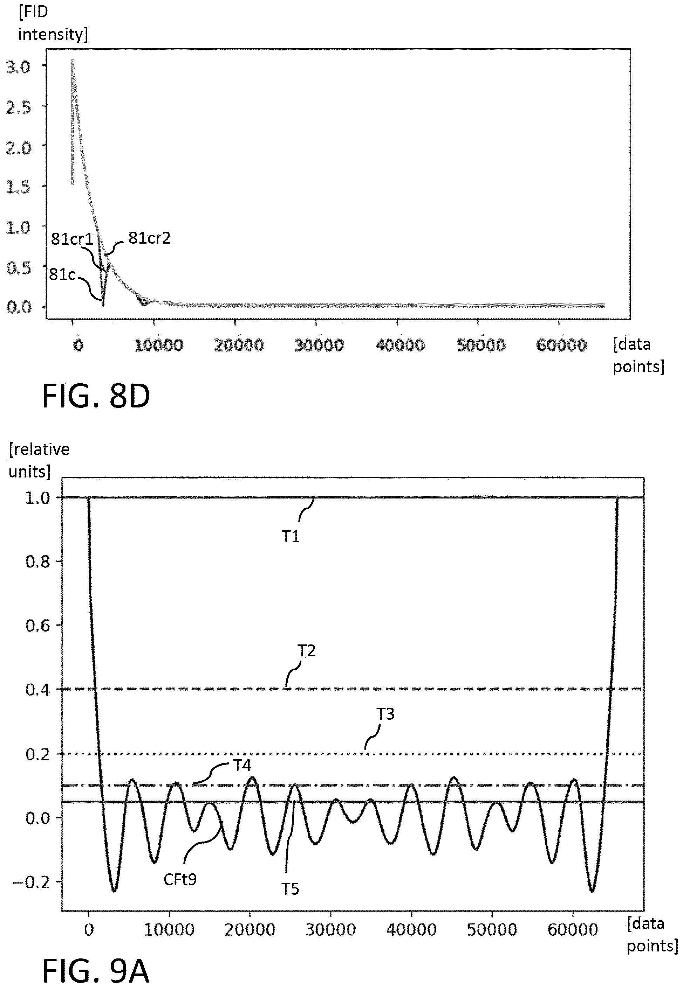

For all values of the transformed correction function being smaller than a predefined threshold, the first regularization function normalizes these values to a predefined threshold while keeping their phase. FIG 9A shows examples for different threshold values (T1=1.0, T2=0.4, T3=0.2, T4=0.1, T5=0.05) which can be in the range of 1 ≥ threshold> 0 for a properly scaled kernel function CFt9 in the time domain. An advantageous threshold value is 0.4.

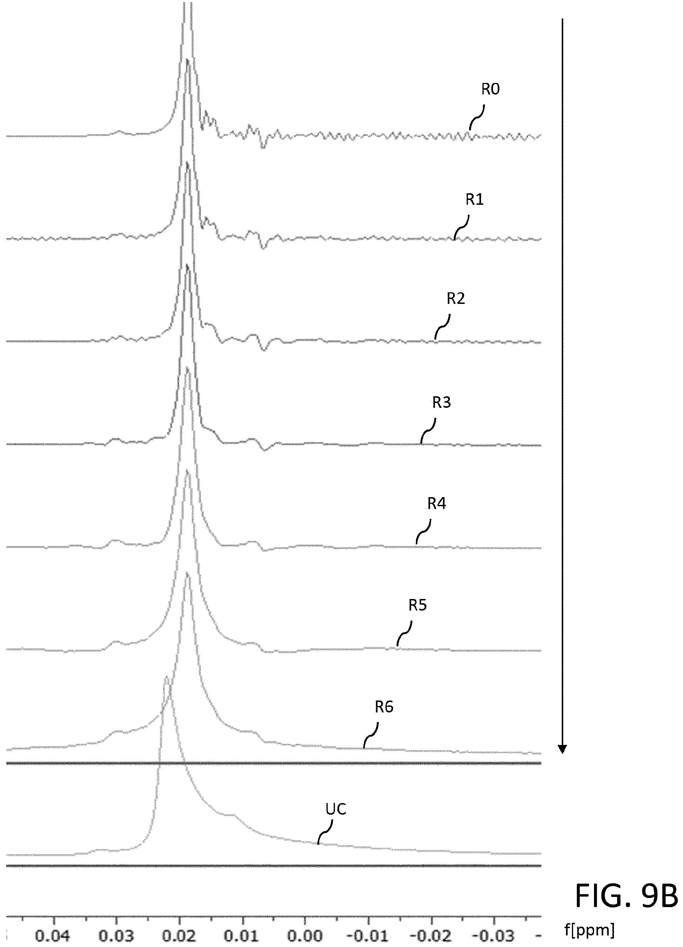

FIG. 9B shows the impact of the first regularization function on the corrected NMR spectrum. NMR spectrum UC at the bottom is the spectrum directly obtain from the NMR measurement data without any correction. The spectra above are corrected NMR spectra using different levels of regularization R0 to R6, with R0 using no regularization at all showing the biggest noise. The regularization increases in the direction of the vertical arrow from R1 to R6. The increase in regularization also leads to an increase of the SNR and an increase of the peak width. Finding a good balance between SNR and peak width is important for determining the sample composition with a high accuracy. A good balance between SNR and peak width has been found with said threshold value of 0.4, R5, for the first implementation of the regularization function.

Turning again briefly to FIG. 9A, data points in regions of the corrected measurement data TDMc, where the respective transformed correction function CFt9 has values below the predefined threshold, can be computed by the above-mentioned alternative implementations.

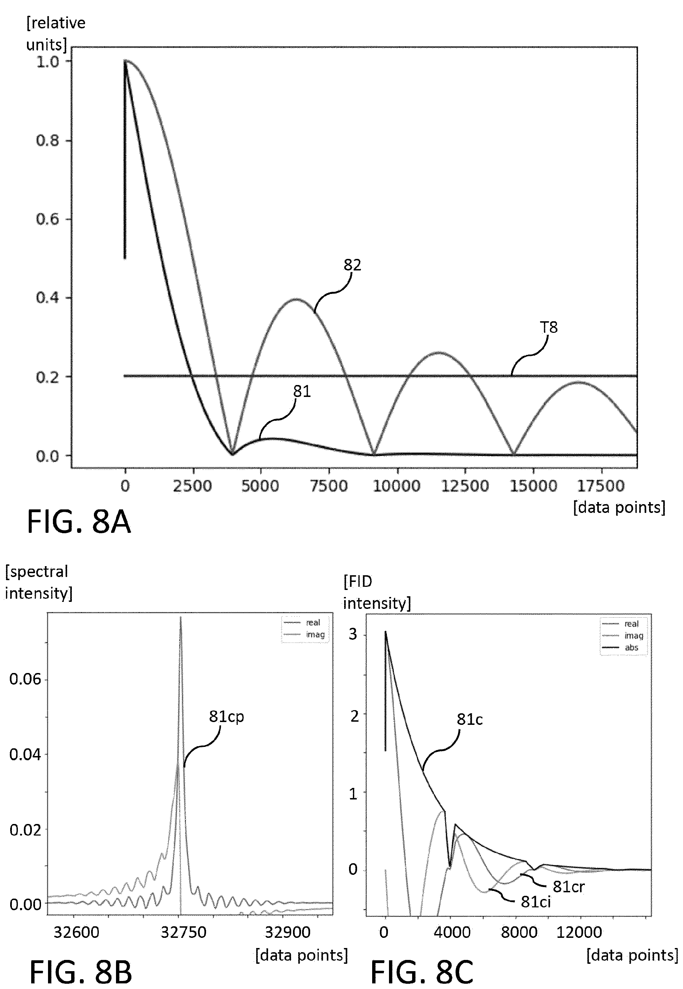

FIG. 8A illustrates a schematic example in the time domain with a threshold T8 = 0.2. The original time domain measurement data 81 scaled to 1 are close to 0 in the tail of data curve 81. The transformed correction function 82 also has local minima close to 0 at certain time points. When now applying the deconvolution to the data 81 by dividing the data curve by the transformed correction function 82 while applying hard thresholding with T8, additional artefacts are generated in the corrected time measurement data as shown in FIG. 8C in the absolute value curve 81c of the deconvoluted NMR measurement data. The absolute value curve 81c is computed from the imaginary and real parts 81ci, 81cr resulting from the deconvolution. The corresponding peak 81cp in the corrected spectrum in the frequency domain (cf., FIG. 8B) obtained from the corrected time domain data 81c already shows a sharp and symmetric shape. However, quite some artefacts in frequency domain are added by the correction because of the artifacts in the corrected time domain data curve 81c. These artifacts can be removed by applying interpolation or soft thresholding to the corrected time domain NMR measurement curve 81c as illustrated in FIG 8D. Curve 81cr2 is computed from curve 81c by using interpolation as second regularization function 161. Curve 81cr1 is computed by using soft thresholding as second regularization function. When computing the corrected spectrum from such curves based on the second regularization function, the artefacts shown in FIG. 8B can be reduced.

Module 160 of system 100 may implement an additional regularization function which can be applied to the corrected time domain NMR measurement curve TDMc. The additional regularization function applies an exponential decay to the Free Induction Decay (FID) signal, reducing the influence of noise by decreasing the weights of values in the tail of the corrected time domain NMR measurement curve (TDMc). The additional regularization function is used in combination with the implementation of the first regularization function which normalizes the values to a predefined threshold while keeping their phase, thereby amplifying the noise in the TDM tail. The additional regularization function reduces this noise amplification.

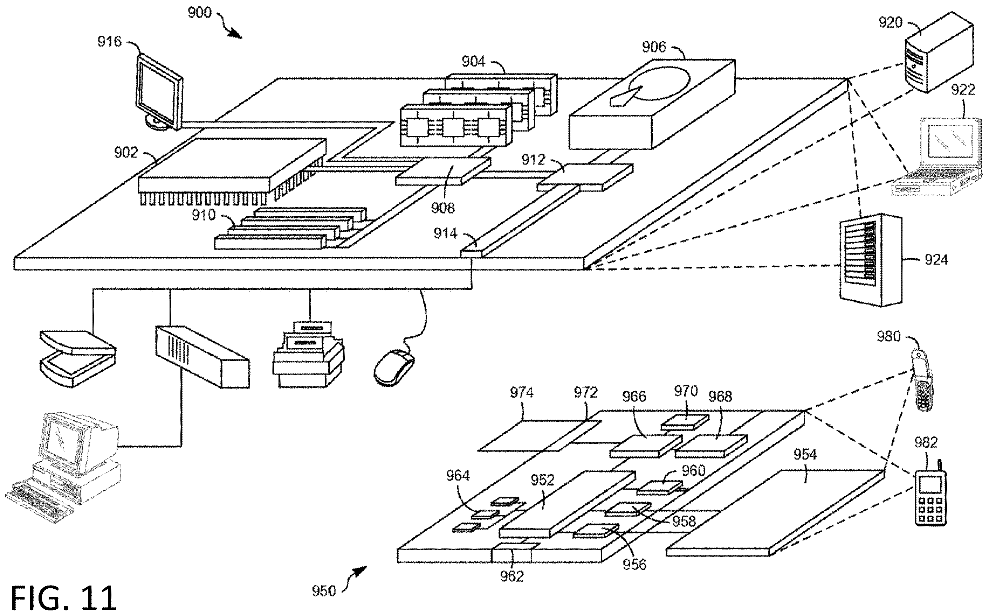

FIG. 11 is a diagram that shows an example of a generic computer device 900 and a generic mobile computer device 950, which may be used with the techniques described here. Computing device 900 is intended to represent various forms of digital computers, such as laptops, desktops, workstations, personal digital assistants, servers, blade servers, mainframes, and other appropriate computers. Advantageously, device 900 has a GPU adapted to process machine learning algorithms. Generic computer device 900 may correspond to the computer system 100 of FIG. 1. Computing device 950 is intended to represent various forms of mobile devices, such as personal digital assistants, cellular telephones, smart phones, and other similar computing devices. For example, computing device 950 may be used as a GUI frontend for a user to visualize the sample composition for the user. The components shown here, their connections and relationships, and their functions, are meant to be exemplary only, and are not meant to limit implementations of the inventions described and/or claimed in this document.

Computing device 900 includes a processor 902, memory 904, a storage device 906, a high-speed interface 908 connecting to memory 904 and high-speed expansion ports 910, and a low-speed interface 912 connecting to low-speed bus 914 and storage device 906. The processor 902, the memory 904, the storage device 906, the high-speed interface 908, the high-speed expansion ports 910 and the low-speed interface 912 are interconnected using various busses, and may be mounted on a common motherboard or in other manners as appropriate. The processor 902 can process instructions for execution within the computing device 900, including instructions stored in the memory 904 or on the storage device 906 to display graphical information for a GUI on an external input/output device, such as display 916 coupled to high-speed interface 908. In other implementations, multiple processing units and/or multiple buses may be used, as appropriate, along with multiple memories and types of memory. Also, multiple computing devices 900 may be connected, with each device providing portions of the necessary operations (e.g., as a server bank, a group of blade servers, or a processing device).

The memory 904 stores information within the computing device 900. In one implementation, the memory 904 is a volatile memory unit or units. In another implementation, the memory 904 is a non-volatile memory unit or units. The memory 904 may also be another form of computer-readable medium, such as a magnetic or optical disk.

The storage device 906 is capable of providing mass storage for the computing device 900. In one implementation, the storage device 906 may be or contain a computer-readable medium, such as a floppy disk device, a hard disk device, an optical disk device, or a tape device, a flash memory or other similar solid state memory device, or an array of devices, including devices in a storage area network or other configurations. A computer program product can be tangibly embodied in an information carrier. The computer program product may also contain instructions that, when executed, perform one or more methods, such as those described above. The information carrier is a computer- or machine-readable medium, such as the memory 904, the storage device 906, or memory on processor 902.

The high-speed interface 908 manages bandwidth-intensive operations for the computing device 900, while the low-speed interface 912 manages lower bandwidth-intensive operations. Such allocation of functions is exemplary only. In one implementation, the high-speed interface 908 is coupled to memory 904, display 916 (e.g., through a graphics processor or accelerator), and to high-speed expansion ports 910, which may accept various expansion cards (not shown). In the implementation, low-speed interface 912 is coupled to storage device 906 and low-speed expansion bus 914. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 900 may be implemented in a number of different forms, as shown in the figure. For example, it may be implemented as a standard server 920, or multiple times in a group of such servers. It may also be implemented as part of a rack server system 924. In addition, it may be implemented in a personal computer such as a laptop computer 922. Alternatively, components from computing device 900 may be combined with other components in a mobile device (not shown), such as computing device 950. Each of such devices may contain one or more of computing device 900, 950, and an entire system may be made up of multiple computing devices 900, 950 communicating with each other.

Computing device 950 includes a processor 952, memory 964, an input/output device such as a display 954, a communication interface 966, and a transceiver 968, among other components. The computing device 950 may also be provided with a storage device, such as a microdrive or other device, to provide additional storage. The processor 952, the memory 964, the display 954, the communication interface 966, and the transceiver 968 are interconnected using various buses, and several of the components may be mounted on a common motherboard or in other manners as appropriate.

The processor 952 can execute instructions within the computing device 950, including instructions stored in the memory 964. The processor may be implemented as a chipset of chips that include separate and multiple analog and digital processing units. The processor may provide, for example, for coordination of the other components of the computing device 950, such as control of user interfaces, applications run by computing device 950, and wireless communication by computing device 950.

Processor 952 may communicate with a user through control interface 958 and display interface 956 coupled to a display 954. The display 954 may be, for example, a TFT LCD (Thin-Film-Transistor Liquid Crystal Display) or an OLED (Organic Light Emitting Diode) display, or other appropriate display technology. The display interface 956 may comprise appropriate circuitry for driving the display 954 to present graphical and other information to a user. The control interface 958 may receive commands from a user and convert them for submission to the processor 952. In addition, an external interface 962 may be provide in communication with processor 952, so as to enable near area communication of computing device 950 with other devices. External interface 962 may provide, for example, for wired communication in some implementations, or for wireless communication in other implementations, and multiple interfaces may also be used.

The memory 964 stores information within the computing device 950. The memory 964 can be implemented as one or more of a computer-readable medium or media, a volatile memory unit or units, or a non-volatile memory unit or units. Expansion memory 984 may also be provided and connected to computing device 950 through expansion interface 982, which may include, for example, a SIMM (Single In Line Memory Module) card interface. Such expansion memory may provide extra storage space for computing device 950, or may also store applications or other information for computing device 950. Specifically, expansion memory may include instructions to carry out or supplement the processes described above, and may include secure information also. Thus, for example, expansion memory may act as a security module for computing device 950, and may be programmed with instructions that permit secure use of computing device 950. In addition, secure applications may be provided via the SIMM cards, along with additional information, such as placing the identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 964, expansion memory, or memory on processor 952, that may be received, for example, over transceiver 968 or external interface 962.

Computing device 950 may communicate wirelessly through communication interface 966, which may include digital signal processing circuitry where necessary. Communication interface 966 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through transceiver 968. In addition, short-range communication may occur, such as using a Bluetooth, WiFi, or other such transceiver (not shown). In addition, GPS (Global Positioning System) receiver module may provide additional navigation- and location-related wireless data to computing device 950, which may be used as appropriate by applications running on computing device 950.

Device 950 may also communicate audibly using audio codec 960, which may receive spoken information from a user and convert it to usable digital information. Audio codec 960 may likewise generate audible sound for a user, such as through a speaker, e.g., in a handset of computing device 950. Such sound may include sound from voice telephone calls, may include recorded sound (e.g., voice messages, music files, etc.) and may also include sound generated by applications operating on computing device 950.

The computing device 950 may be implemented in a number of different forms, as shown in the figure. For example, it may be implemented as a cellular telephone 980. It may also be implemented as part of a smart phone, personal digital assistant, or other similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" and "computer-readable medium" refer to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

To provide for interaction with a user, the systems and techniques described here can be implemented on a computer having a display device (e.g., a CRT (cathode ray tube) or LCD (liquid crystal display) monitor) for displaying information to the user and a keyboard and a pointing device (e.g., a mouse or a trackball) by which the user can provide input to the computer. Other kinds of devices can be used to provide for interaction with a user as well; for example, feedback provided to the user can be any form of sensory feedback (e.g., visual feedback, auditory feedback, or tactile feedback); and input from the user can be received in any form, including acoustic, speech, or tactile input.

The systems and techniques described here can be implemented in a computing device that includes a back end component (e.g., as a data server), or that includes a middleware component (e.g., an application server), or that includes a front end component (e.g., a client computer having a graphical user interface or a Web browser through which a user can interact with an implementation of the systems and techniques described here), or any combination of such back end, middleware, or front end components. The components of the system can be interconnected by any form or medium of digital data communication (e.g., a communication network). Examples of communication networks include a local area network ("LAN"), a wide area network ("WAN"), and the Internet.

The computing device can include clients and servers. A client and server are generally remote from each other and typically interact through a communication network. The relationship of client and server arises by virtue of computer programs running on the respective computers and having a client-server relationship to each other.

A number of embodiments have been described. Nevertheless, it will be understood that various modifications may be made without departing from the spirit and scope of the invention.

In addition, the logic flows depicted in the figures do not require the particular order shown, or sequential order, to achieve desirable results. In addition, other steps may be provided, or steps may be eliminated, from the described flows, and other components may be added to, or removed from, the described systems. Accordingly, other embodiments are within the scope of the following claims.

## Claims

1. A computer-implemented method (1000) for improving an NMR measurement result obtained by an NMR spectrometer (200) for a sample (240), comprising:
Receiving (1100) a magnetic field map (BOma) for the actual main magnetic field (B0) of the NMR spectrometer (200) with the sample (240) being located at its measuring position, wherein the magnetic field map (BOma) is obtained from a measurement of the deviation of the actual magnetic field from an ideal homogenous field B₀ as a function of spatial location in the sample, wherein magnetic field measurement points are taken at z-intervals along the z-direction of the sample;
Receiving (1200) a time domain NMR measurement (TDM) of the sample (240);
Computing (1300), in the frequency domain, a correction function (CFf1) for the NMR measurement (TDM) based on the received magnetic field map (BOma), by determining, for each of a plurality of predefined frequency intervals which covers a frequency range with B₀ deviations, the total length of z-intervals with frequency values in the respective frequency interval, wherein the determined total length is the value of the correction function for the respective frequency interval;
Transforming (1400) the correction function (CFf1) into a transformed correction function in the time domain;
Applying (1420) a first regularization function (141) to the transformed correction function (CFt1) to balance resolution vs. signal-to-noise ratio or the appearance of artefacts by setting all values of the transformed correction function (CFt1) being smaller than a predefined threshold (T1 to T5) to said predefined threshold while keeping their phase, wherein the transformed correction function after regularization is used as the transformed correction function in the following step;
Dividing (1500) the time domain NMR measurement (TDM) by the transformed correction function (CFt1) to obtain a corrected time domain NMR measurement curve (TDMc); and
Transforming (1600) the corrected time domain NMR measurement curve (TDMc) into the frequency domain to obtain an NMR spectrum (S1) of the sample (240) with symmetrized peaks and overlapping peaks being resolved.

2. The method of claim 1, wherein in the computing (1300) step, the total length of z-intervals is calculated by determining, for each of the plurality of predefined frequency intervals which covers a frequency range with B₀ deviations, the number of data points in the received magnetic field map with frequency values in the respective frequency interval, wherein the determined number of data points is used as the value of the correction function for the respective frequency interval.

3. The method of claim 1 or 2, further comprising:
If the deviation (ΔB) is equal to or greater than a predefined threshold (T), providing (1140) control instructions to one or more shim coils (221) of the NMR spectrometer to improve the homogeneity of the main magnetic field B₀, and repeating the receiving (1100) a magnetic field map step until said deviation (ΔB) falls below the predefined threshold.

4. The method of any of the previous claims, wherein the received magnetic field map further includes deviations (B1ma) of the actual magnetic field caused by the B₁ field of the NMR spectrometer's RF coil (222).

5. The method of any of the previous claims, wherein the received magnetic field map is a three-dimensional shim map.

6. The method of any of the previous claims, further comprising:
Applying (1580) a second regularization function (161) to the corrected time domain NMR measurement curve (TDMc), wherein the second regularization function (161) applies interpolation or soft thresholding to the values of the corrected time domain NMR measurement curve (TDMc) for such data points where the transformed correction function (CFt1) is smaller than the predefined threshold.

7. The method of any of the previous claims, further comprising:
Filtering (1220) the received time domain NMR measurement (TDM) before applying the correction function to filter out signal contributions of known components disturbing the correction by using a respective predefined frequency filter.

8. The method of claim 7, wherein the contribution of a residual solvent is filtered out.

9. The method of any of the previous claims, wherein the received magnetic field map (BOma) and time domain NMR measurement (TDM) were obtained after the NMR spectrometer (200) has performed at least one initial shimming step.

10. The method of any of the previous claims, wherein computing the correction function comprises interpolation of frequency intervals between points of the received magnetic field map.

11. A computer program product for improving an NMR measurement result obtained by an NMR spectrometer (200) for a sample (240), comprising computer-readable instructions that, when loaded into a memory of a computing device and processed by at least one processor of the computing device, cause the computing device to perform the method steps of the computer-implemented method according to any of the previous claims.

12. A computer system (100) for improving an NMR measurement result obtained by an NMR spectrometer (200) for a sample (240), comprising:
A data interface adapted to receive a magnetic field map (BOma) for the actual main magnetic field (B0) of the NMR spectrometer (200) with the sample (240) being located at its measuring position, wherein the magnetic field map (BOma) is obtained from a measurement of the deviation of the actual magnetic field from an ideal homogenous field B₀ as a function of spatial location in the sample, wherein magnetic field measurement points are taken at z-intervals along the z-direction of the sample, and to receive a time domain NMR measurement (TDM) of the sample (240);
A function generator module (130) adapted to compute, in the frequency domain, a correction function (CFf1) for the NMR measurement (TDM) based on the received magnetic field map (BOma), by determining, for each of a plurality of predefined frequency intervals which covers a frequency range with B₀ deviations, the total length of z-intervals with frequency values in the respective frequency interval, wherein the determined total length is the value of the correction function for the respective frequency interval;
A frequency-to-time-domain transformation module (140) adapted to transform the correction function (CFf1) into a transformed correction function in the time domain;
A first regularization function (141) adapted to be applied to the transformed correction function (CFt1) to balance resolution vs. signal-to-noise ratio or the appearance of artefacts by setting all values of the transformed correction function (CFt1) being smaller than a predefined threshold (T1 to T5) to said predefined threshold while keeping their phase, wherein the transformed correction function after regularization is used as the transformed correction function by a correction module (150),
The correction module (150) adapted to divide the time domain NMR measurement (TDM) by the transformed correction function (CFt1) to obtain a corrected time domain NMR measurement curve (TDMc); and
A time-to-frequency-domain transformation module (160) adapted to transform the corrected time domain NMR measurement curve (TDMc) into the frequency domain to obtain an NMR spectrum (S1) of the sample (240) with symmetrized peaks and overlapping peaks being resolved.

13. The system of claim 12, further comprising:
A shim control module (110) adapted to check if said deviation (ΔB) is equal to or greater than a predefined threshold (T), and if yes, to provide control instructions (Cl_s) for one or more shim coils (221) to the NMR spectrometer to improve the homogeneity of the main magnetic field B₀.

14. The system of claim 12 or 13, further comprising:
A filter module (120) adapted to filter the received time domain NMR measurement (TDM) before applying the correction function to filter out signal contributions of known components disturbing the correction by using a respective predefined frequency filter.

15. The system of any of claims 12 to 14, further comprising:
a second regularization function (161) adapted to be applied to the corrected time domain NMR measurement curve (TDMc), wherein the second regularization function (161) applies interpolation or soft thresholding to the values of the corrected time domain NMR measurement curve (TDMc) for such data points where the transformed correction function (CFt1) is smaller than the predefined threshold.

## Patentansprüche

1. Ein computerimplementiertes Verfahren (1000) zur Verbesserung eines NMR-Messergebnisses, das mit einem NMR-Spektrometer (200) für eine Probe (240) ermittelt wurde, mit den folgenden Schritten:
Empfangen (1100) einer Magnetfeldkarte (BOma) für das tatsächliche Hauptmagnetfeld (B0) des NMR-Spektrometers (200), wobei sich die Probe (240) an ihrer Messposition befindet, wobei die Magnetfeldkarte (BOma) aus einer Messung der Abweichung des tatsächlichen Magnetfelds von einem idealen homogenen Feld B₀ als Funktion der räumlichen Position in der Probe gewonnen wird, wobei Magnetfeldmesspunkte in z-Intervallen entlang der z-Richtung der Probe erfasst werden;
Empfangen (1200) einer Zeitbereichs-NMR-Messung (TDM) der Probe (240);
Berechnen (1300), im Frequenzbereich einer Korrekturfunktion (CFf1) für die NMR-Messung (TDM) auf der Grundlage der empfangenen Magnetfeldkarte (BOma), indem für jedes einer Vielzahl vordefinierter Frequenzintervalle, die einen Frequenzbereich mit B₀-Abweichungen abdecken, die Gesamtlänge der z-Intervalle mit Frequenzwerten im jeweiligen Frequenzintervall bestimmt wird, wobei die bestimmte Gesamtlänge den Wert der Korrekturfunktion für das jeweilige Frequenzintervall darstellt;
Transformieren (1400) der Korrekturfunktion (CFf1) in eine transformierte Korrekturfunktion im Zeitbereich;
Anwenden (1420) einer ersten Regularisierungsfunktion (141) auf die transformierte Korrekturfunktion (CFt1), um ein Gleichgewicht zwischen Auflösung und Signal-RauschVerhältnis oder dem Auftreten von Artefakten herzustellen, indem alle Werte der transformierten Korrekturfunktion (CFt1), die kleiner als ein vordefinierter Schwellenwert (T1 bis T5) sind, auf diesen vordefinierten Schwellenwert gesetzt werden, während ihre Phase beibehalten wird, wobei die transformierte Korrekturfunktion nach der Regularisierung als transformierte Korrekturfunktion im folgenden Schritt verwendet wird;
Teilen (1500) der Zeitbereichs-NMR-Messung (TDM) durch die transformierte Korrekturfunktion (CFt1), um eine korrigierte Zeitbereichs-NMR-Messkurve (TDMc) zu erhalten; und
Transformieren (1600) der korrigierten Zeitbereichs-NMR-Messkurve (TDMc) in den Frequenzbereich, um ein NMR-Spektrum (S1) der Probe (240) zu erhalten, bei dem symmetrisierte Peaks und überlappende Peaks aufgelöst sind.

2. Verfahren nach Anspruch 1, wobei im Berechnungsschritt (1300) die Gesamtlänge der z-Intervalle berechnet wird, indem für jedes der mehreren vordefinierten Frequenzintervalle, die einen Frequenzbereich mit B₀-Abweichungen abdecken, die Anzahl der Datenpunkte in der empfangenen Magnetfeldkarte mit Frequenzwerten im jeweiligen Frequenzintervall ermittelt wird, wobei die ermittelte Anzahl von Datenpunkten als Wert der Korrekturfunktion für das jeweilige Frequenzintervall verwendet wird.

3. Verfahren nach Anspruch 1 oder 2, das ferner umfasst:
Wenn die Abweichung (ΔB) gleich oder größer als ein vordefinierter Schwellenwert (T) ist, ausgegeben (1140) von Steuerbefehlen an eine oder mehrere Shim-Spulen (221) des NMR-Spektrometers, um die Homogenität des Hauptmagnetfelds B₀ zu verbessern, und wiederholen des Schritts des Empfangens (1100) einer Magnetfeldkarte, bis die Abweichung (ΔB) unter den vordefinierten Schwellenwert fällt.

4. Verfahren nach einem der vorstehenden Ansprüche, wobei die empfangene Magnetfeldkarte ferner Abweichungen (B1ma) des tatsächlichen Magnetfelds enthält, die durch das B₁-Feld der HF-Spule (222) des NMR-Spektrometers verursacht werden.

5. Verfahren nach einem der vorstehenden Ansprüche, wobei die empfangene Magnetfeldkarte eine dreidimensionale Shim-Karte ist.

6. Verfahren nach einem der vorstehenden Ansprüche, das ferner umfasst:
Anwenden (1580) einer zweiten Regularisierungsfunktion (161) auf die korrigierte NMR-Messkurve im Zeitbereich (TDMc), wobei die zweite Regularisierungsfunktion (161) eine Interpolation oder ein weiches Schwellenwertverfahren auf die Werte der korrigierten NMR-Messkurve im Zeitbereich (TDMc) für jene Datenpunkte anwendet, bei denen die transformierte Korrekturfunktion (CFt1) kleiner als der vordefinierte Schwellenwert ist.

7. Verfahren nach einem der vorstehenden Ansprüche, das ferner umfasst:
das Filtern (1220) der empfangenen Zeitbereichs-NMR-Messung (TDM) vor der Anwendung der Korrekturfunktion, um Signalanteile bekannter Komponenten, die die Korrektur stören, unter Verwendung eines entsprechenden vordefinierten Frequenzfilters herauszufiltern.

8. Verfahren nach Anspruch 7, wobei der Beitrag eines Restlösungsmittels herausgefiltert wird.

9. Verfahren nach einem der vorstehenden Ansprüche, wobei die empfangene Magnetfeldkarte (BOma) und die Zeitbereichs-NMR-Messung (TDM) gewonnen wurden, nachdem das NMR-Spektrometer (200) mindestens einen anfänglichen Shimming-Schritt durchgeführt hat.

10. Verfahren nach einem der vorstehenden Ansprüche, wobei die Berechnung der Korrekturfunktion eine Interpolation von Frequenzintervallen zwischen Punkten der empfangenen Magnetfeldkarte umfasst.

11. Ein Computerprogrammprodukt zur Verbesserung eines NMR-Messergebnisses, das von einem NMR-Spektrometer (200) für eine Probe (240) erhalten wurde, umfassend computerlesbare Anweisungen, die, wenn sie in einen Speicher einer Recheneinrichtung geladen und von mindestens einem Prozessor der Recheneinrichtung verarbeitet werden, bewirken, dass die Recheneinrichtung die Verfahrensschritte des computerimplementierten Verfahrens gemäß einem der vorstehenden Ansprüche ausführt.

12. Ein Computersystem (100) zur Verbesserung eines NMR-Messergebnisses, das von einem NMR-Spektrometer (200) für eine Probe (240) ermittelt wurde, umfassend:
eine Datenschnittstelle, die dazu ausgelegt ist, eine Magnetfeldkarte (BOma) für das tatsächliche Hauptmagnetfeld (B0) des NMR-Spektrometers (200) zu empfangen, wobei sich die Probe (240) an ihrer Messposition befindet, wobei die Magnetfeldkarte (BOma) aus einer Messung der Abweichung des tatsächlichen Magnetfelds von einem idealen homogenen Feld B₀ als Funktion der räumlichen Position in der Probe gewonnen wird, wobei Magnetfeldmesspunkte in z-Intervallen entlang der z-Richtung der Probe erfasst werden, und zum Empfangen einer Zeitbereichs-NMR-Messung (TDM) der Probe (240);
Ein Funktionsgeneratormodul (130), das dazu ausgelegt ist, im Frequenzbereich eine Korrekturfunktion (CFf1) für die NMR-Messung (TDM) auf der Grundlage der empfangenen Magnetfeldkarte (BOma) zu berechnen, indem es für jedes einer Vielzahl vordefinierter Frequenzintervalle, die einen Frequenzbereich mit B₀-Abweichungen abdecken, die Gesamtlänge der z-Intervalle mit Frequenzwerten im jeweiligen Frequenzintervall bestimmt, wobei die ermittelte Gesamtlänge den Wert der Korrekturfunktion für das jeweilige Frequenzintervall darstellt;
ein Frequenz-Zeit-Domänen-Transformationsmodul (140), das dazu ausgelegt ist, die Korrekturfunktion (CFf1) in eine transformierte Korrekturfunktion im Zeitbereich umzuwandeln;
eine erste Regularisierungsfunktion (141), die dazu ausgelegt ist, auf die transformierte Korrekturfunktion (CFt1), um ein Gleichgewicht zwischen Auflösung und Signal-RauschVerhältnis oder dem Auftreten von Artefakten herzustellen, indem alle Werte der transformierten Korrekturfunktion (CFt1), die kleiner als ein vordefinierter Schwellenwert (T1 bis T5) sind, auf diesen vordefinierten Schwellenwert gesetzt werden, wobei ihre Phase beibehalten wird, wobei die transformierte Korrekturfunktion nach der Regularisierung von einem Korrekturmodul (150) als transformierte Korrekturfunktion verwendet wird;
das Korrekturmodul (150), das dazu ausgelegt ist, die NMR-Messung im Zeitbereich (TDM) durch die transformierte Korrekturfunktion (CFt1) zu dividieren, um eine korrigierte NMR-Messkurve im Zeitbereich (TDMc) zu erhalten; und
ein Zeit-Frequenz-Transformationsmodul (160), das dazu ausgelegt ist, die korrigierte NMR-Messkurve im Zeitbereich (TDMc) in den Frequenzbereich zu transformieren, um ein NMR-Spektrum (S1) der Probe (240) zu erhalten, bei dem symmetrierte Peaks und überlappende Peaks aufgelöst sind.

13. Das System nach Anspruch 12, ferner umfassend:
ein Shim-Steuermodul (110), das dazu ausgelegt ist, zu prüfen, ob die Abweichung (ΔB) gleich oder größer als ein vordefinierter Schwellenwert (T) ist, und, falls ja, Steuerbefehle (CI_s) für eine oder mehrere Shim-Spulen (221) an das NMR-Spektrometer zu liefern, um die Homogenität des Hauptmagnetfelds B₀ zu verbessern.

14. Das System nach Anspruch 12 oder 13, das ferner umfasst:
ein Filtermodul (120), das dazu ausgelegt ist, die empfangene NMR-Zeitbereichsmessung (TDM) vor der Anwendung der Korrekturfunktion zu filtern, um Signalanteile bekannter Komponenten, die die Korrektur stören, unter Verwendung eines entsprechenden vordefinierten Frequenzfilters herauszufiltern.

15. Das System nach einem der Ansprüche 12 bis 14, das ferner umfasst:
eine zweite Regularisierungsfunktion (161), die dazu ausgelegt ist, auf die korrigierte Zeitbereichs-NMR-Messkurve (TDMc) angewendet zu werden, wobei die zweite Regularisierungsfunktion (161) eine Interpolation oder ein weiches Schwellenwertverfahren auf die Werte der korrigierten Zeitbereichs-NMR-Messkurve (TDMc) für solche Datenpunkte anwendet, bei denen die transformierte Korrekturfunktion (CFt1) kleiner als der vordefinierte Schwellenwert ist.

## Revendications

1. Procédé mis en œuvre par ordinateur (1000) destiné à améliorer un résultat de mesure RMN obtenu par un spectromètre RMN (200) pour un échantillon (240), comprenant :
la réception (1100) d'une carte de champ magnétique (BOma) correspondant au champ magnétique principal réel (B0) du spectromètre RMN (200) avec l'échantillon (240) situé à sa position de mesure, la carte de champ magnétique (BOma) étant obtenue à partir d'une mesure de l'écart entre le champ magnétique réel et un champ homogène idéal B₀ en fonction de la position spatiale dans l'échantillon, les points de mesure du champ magnétique étant prélevés à des intervalles z le long de la direction z de l'échantillon ;
Réception (1200) d'une mesure RMN dans le domaine temporel (TDM) de l'échantillon (240) ;
Calcul (1300), dans le domaine fréquentiel, d'une fonction de correction (CFf1) pour la mesure RMN (TDM) sur la base de la carte de champ magnétique reçue (BOma), en déterminant, pour chacun d'une pluralité d'intervalles de fréquence prédéfinis couvrant une plage de fréquences présentant des écarts par rapport à B₀, la longueur totale des intervalles z comportant des valeurs de fréquence dans l'intervalle de fréquence respectif, la longueur totale déterminée constituant la valeur de la fonction de correction pour l'intervalle de fréquence respectif ;
Transformer (1400) la fonction de correction (CFf1) en une fonction de correction transformée dans le domaine temporel ;
Appliquer (1420) une première fonction de régularisation (141) à la fonction de correction transformée (CFt1) afin d'équilibrer la résolution par rapport au rapport signal/bruit ou à l'apparition d'artefacts, en fixant toutes les valeurs de la fonction de correction transformée (CFt1) inférieures à un seuil prédéfini (T1 à T5) à ledit seuil prédéfini tout en conservant leur phase, la fonction de correction transformée après régularisation étant utilisée comme fonction de correction transformée à l'étape suivante ;
Diviser (1500) la mesure RMN dans le domaine temporel (TDM) par la fonction de correction transformée (CFt1) pour obtenir une courbe de mesure RMN corrigée dans le domaine temporel (TDMc) ; et
Transformer (1600) la courbe de mesure RMN dans le domaine temporel corrigée (TDMc) dans le domaine fréquentiel afin d'obtenir un spectre RMN (S1) de l'échantillon (240) dans lequel les pics symétrisés et les pics qui se chevauchent sont résolus.

2. Procédé selon la revendication 1, dans lequel, lors de l'étape de calcul (1300), la longueur totale des intervalles z est calculée en déterminant, pour chacun des multiples intervalles de fréquence prédéfinis couvrant une plage de fréquences présentant des écarts par rapport à B₀, le nombre de points de données dans la carte de champ magnétique reçue dont les valeurs de fréquence se situent dans l'intervalle de fréquence respectif, le nombre de points de données ainsi déterminé étant utilisé comme valeur de la fonction de correction pour l'intervalle de fréquence respectif.

3. Procédé selon la revendication 1 ou 2, comprenant en outre :
Si l'écart (ΔB) est égal ou supérieur à un seuil prédéfini (T), fournir (1140) des instructions de commande à une ou plusieurs bobines de compensation (221) du spectromètre RMN afin d'améliorer l'homogénéité du champ magnétique principal B₀, et répéter l'étape de réception (1100) d'une carte de champ magnétique jusqu'à ce que ledit écart (ΔB) tombe en dessous du seuil prédéfini.

4. Procédé selon l'une quelconque des revendications précédentes, dans lequel la carte de champ magnétique reçue comprend en outre des écarts (B1ma) du champ magnétique réel causés par le champ B₁ de la bobine RF (222) du spectromètre RMN.

5. Procédé selon l'une quelconque des revendications précédentes, dans lequel la carte de champ magnétique reçue est une carte de shim tridimensionnelle.

6. Procédé selon l'une quelconque des revendications précédentes, comprenant en outre :
l'application (1580) d'une deuxième fonction de régularisation (161) à la courbe de mesure RMN dans le domaine temporel corrigée (TDMc), dans laquelle la deuxième fonction de régularisation (161) applique une interpolation ou un seuillage souple aux valeurs de la courbe de mesure RMN dans le domaine temporel corrigée (TDMc) pour les points de données pour lesquels la fonction de correction transformée (CFt1) est inférieure au seuil prédéfini.

7. Procédé selon l'une quelconque des revendications précédentes, comprenant en outre :
le filtrage (1220) de la mesure RMN dans le domaine temporel (TDM) reçue avant d'appliquer la fonction de correction, afin d'éliminer les contributions de signaux provenant de composants connus perturbant la correction, à l'aide d'un filtre de fréquence prédéfini correspondant.

8. Procédé selon la revendication 7, dans lequel la contribution d'un solvant résiduel est éliminée par filtrage.

9. Procédé selon l'une quelconque des revendications précédentes, dans lequel la carte de champ magnétique reçue (BOma) et la mesure RMN dans le domaine temporel (TDM) ont été obtenues après que le spectromètre RMN (200) a effectué au moins une étape initiale de shimming.

10. Procédé selon l'une quelconque des revendications précédentes, dans lequel le calcul de la fonction de correction comprend l'interpolation d'intervalles de fréquence entre des points de la carte de champ magnétique reçue.

11. Produit logiciel destiné à améliorer un résultat de mesure RMN obtenu par un spectromètre RMN (200) pour un échantillon (240), comprenant des instructions lisibles par ordinateur qui, lorsqu'elles sont chargées dans une mémoire d'un dispositif informatique et traitées par au moins un processeur dudit dispositif, amènent ce dernier à exécuter les étapes du procédé mis en œuvre par ordinateur selon l'une quelconque des revendications précédentes.

12. Système informatique (100) destiné à améliorer un résultat de mesure RMN obtenu par un spectromètre RMN (200) pour un échantillon (240), comprenant :
une interface de données adaptée pour recevoir une carte de champ magnétique (BOma) correspondant au champ magnétique principal réel (B0) du spectromètre RMN (200) lorsque l'échantillon (240) se trouve dans sa position de mesure, dans laquelle la carte de champ magnétique (BOma) est obtenue à partir d'une mesure de l'écart entre le champ magnétique réel et un champ homogène idéal B₀ en fonction de l'emplacement spatial dans l'échantillon, les points de mesure du champ magnétique étant prélevés à des intervalles z le long de la direction z de l'échantillon, et à recevoir une mesure RMN dans le domaine temporel (TDM) de l'échantillon (240) ;
Un module générateur de fonctions (130) adapté pour calculer, dans le domaine fréquentiel, une fonction de correction (CFf1) pour la mesure RMN (TDM) sur la base de la carte de champ magnétique (BOma) reçue, en déterminant, pour chacun d'une pluralité d'intervalles de fréquence prédéfinis couvrant une plage de fréquences présentant des écarts par rapport à B₀, la longueur totale des intervalles z dont les valeurs de fréquence se situent dans l'intervalle de fréquence respectif, la longueur totale déterminée correspondant à la valeur de la fonction de correction pour l'intervalle de fréquence respectif;
Un module de transformation du domaine fréquentiel vers le domaine temporel (140) adapté pour transformer la fonction de correction (CFf1) en une fonction de correction transformée dans le domaine temporel ;
Une première fonction de régularisation (141) adaptée pour être appliquée à la fonction de correction transformée (CFt1) afin d'équilibrer la résolution par rapport au rapport signal/bruit ou à l'apparition d'artefacts, en ajustant toutes les valeurs de la fonction de correction transformée (CFt1) inférieures à un seuil prédéfini (T1 à T5) à ledit seuil prédéfini tout en conservant leur phase, la fonction de correction transformée après régularisation étant utilisée comme fonction de correction transformée par un module de correction (150),
le module de correction (150) adapté pour diviser la mesure RMN dans le domaine temporel (TDM) par la fonction de correction transformée (CFt1) afin d'obtenir une courbe de mesure RMN corrigée dans le domaine temporel (TDMc) ; et
Un module de transformation du domaine temporel vers le domaine fréquentiel (160) adapté pour transformer la courbe de mesure RMN dans le domaine temporel corrigée (TDMc) dans le domaine fréquentiel afin d'obtenir un spectre RMN (S1) de l'échantillon (240) présentant des pics symétrisés et des pics superposés résolus.

13. Système selon la revendication 12, comprenant en outre :
un module de commande de shim (110) adapté pour vérifier si ledit écart (ΔB) est égal ou supérieur à un seuil prédéfini (T), et si tel est le cas, pour fournir au spectromètre RMN des instructions de commande (Cl_s) destinées à une ou plusieurs bobines de shim (221) afin d'améliorer l'homogénéité du champ magnétique principal B₀.

14. Système selon la revendication 12 ou 13, comprenant en outre :
un module de filtrage (120) adapté pour filtrer la mesure RMN dans le domaine temporel (TDM) reçue avant d'appliquer la fonction de correction, afin d'éliminer les contributions de signaux provenant de composantes connues perturbant la correction, en utilisant un filtre de fréquence prédéfini respectif.

15. Système selon l'une quelconque des revendications 12 à 14, comprenant en outre :
une deuxième fonction de régularisation (161) adaptée pour être appliquée à la courbe de mesure RMN dans le domaine temporel corrigée (TDMc), dans laquelle la deuxième fonction de régularisation (161) applique une interpolation ou un seuillage souple aux valeurs de la courbe de mesure RMN dans le domaine temporel corrigée (TDMc) pour les points de données pour lesquels la fonction de correction transformée (CFt1) est inférieure au seuil prédéfini.
